# EUROPEAN PATENT APPLICATION

(11) **EP 4 851 326 A1**
(43) Date of publication of application: **09.12.2026**
(21) Application number: 25902716.7
(22) Date of filing: 11.06.2025
(51) Int. Cl.: C23C 16/27, C23C 16/52, C01B 32/25, C01B 32/26, C23C 16/46

(54) **METHOD FOR PREPARING LARGE-AREA DIAMOND AT HIGH TEMPERATURE USING HFCVD METHOD**

(30) Priority: 13.12.2024 CN 202411839366
(71) Applicant: Sinoma Synthetic Crystals (Shandong) Co., Ltd., Jinan, Shandong 250200 (CN); China National Building Material Group Co., Ltd., Beijing 100080 (CN)
(72) Inventor: CAO, Yanxin, Jinan, Shandong 250200 (CN); ZHAO, Xiaobo, Jinan, Shandong 250200 (CN); WANG, Yubao, Jinan, Shandong 250200 (CN); WEI, Huayang, Jinan, Shandong 250200 (CN); LIU, Mingzhao, Jinan, Shandong 250200 (CN)
(74) Representative: Chung, Hoi Kan
(86) International application number: PCT/CN2025/100334
(87) International publication number: WO 2026/123622

(57) **Abstract**

Disclosed in the present invention is a method for preparing large-area diamond at a high temperature using a hot-filament chemical vapor deposition (HFCVD) method, comprising the following steps: producing diamond by means of an HFCVD apparatus, wherein the diameter of the produced diamond is greater than or equal to 200 mm, the HFCVD apparatus is provided with a deposition space, a hot-filament assembly, a deposition base, and a temperature compensation apparatus are provided inside the deposition space, the hot-filament assembly comprises a plurality of parallel hot filaments, the deposition base comprises a substrate and a cooling interlayer mechanism, the substrate is placed on the upper surface of the cooling interlayer mechanism, and the temperature compensation apparatus comprises a substrate compensation apparatus; adjusting a hot-filament spacing D between the parallel hot filaments, wherein D is equal to 4-12 mm; on the basis of the hot-filament spacing D, adjusting a substrate spacing H between a hot-filament plane and the substrate by means of a first formula; and after cooling, discharging hydrogen from a furnace, and removing a diamond film layer from the surface of a deposition substrate to obtain diamond, thereby achieving the preparation of large-area and high-quality diamond having few impurities and defects.

## Description

### TECHNICAL FIELD

The present invention relates to the field of diamond preparation, and in particular to a method for preparing large-area diamond at a high temperature by hot filament chemical vapor deposition (HFCVD).

### BACKGROUND

Diamond is a common macroscopic crystal composed of carbon. Diamond has a series of excellent physical and chemical properties, such as high hardness, a high thermal conductivity, a low thermal expansion coefficient, good optical transmittance, and chemical inertness. Diamond has very broad application prospects in fields such as aerospace, military, mechanics, and electronic information. Natural diamond has limited reserves and small dimensions, which greatly limits its industrial applications. Consequently, artificial diamond technology has gradually become a research hotspot.

A conventional manner for preparing artificial diamonds is preparing the artificial diamonds under high temperature and high pressure. However, this manner can only prepare diamond grains or diamond powder. To prepare a block, a metal binder must be added, which is prone to causing performance degradation of the prepared diamond. A diamond film or a diamond sheet with high purity can be prepared by Chemical Vapor Deposition (CVD).

Manners for preparing a diamond thin film by CVD can be roughly classified into the following four categories: 1) thermal decomposition CVD manners, including a chemical transport reaction manner, a hot filament manner, and an oxyacetylene flame manner; 2) direct current plasma CVD manners, including a low-voltage direct current discharge manner, a medium-voltage direct current discharge manner, a hollow cathode discharge manner, a direct current arc manner, and a direct current plasma jet manner; 3) radio frequency plasma CVD manners, including a low-pressure glow discharge manner and a thermal plasma CVD manner; 4) microwave plasma CVD manners, including a 2.45 GHz plasma manner, which has a high production cost. The direct current plasma CVD manners and the radio frequency plasma CVD manners have high costs for large-scale preparation and cannot prepare large-area diamond, and the diameter of the diamond is not greater than 150 mm. A CVD diamond prepared by the hot filament manner has characteristics such as low operation cost, relatively simple equipment, high production efficiency, and a large product size. However, the CVD diamond prepared by the hot filament manner has the following problems.

The deposited diamond has many impurity defects. It is difficult to ensure a high deposition rate and deposition quality, and expanding a deposition area tends to cause problems such as difficulty in controlling a thermal field and uneven deposition.

Therefore, how to prepare large-area and high-quality diamond with few impurities and defects has become a problem urgently needing to be solved in the art.

### SUMMARY

To solve the above technical problem, a method for preparing large-area diamond at a high temperature by HFCVD is provided, so as to prepare large-area and high-quality diamonds with fewer impurities and defects.

According to the present invention, a method for preparing large-area diamond at a high temperature by HFCVD is provided. The method includes the following steps.

The diamond is prepared using an HFCVD apparatus, wherein a diameter of the diamond prepared is greater than or equal to 200 mm.

The HFCVD apparatus is provided with a deposition chamber. The deposition chamber includes a hot-filament assembly, a deposition platform, and a temperature compensation device.

The hot-filament assembly includes a plurality of parallel hot filaments.

The deposition platform includes a substrate and a cooling sandwich structure, and the substrate is placed on a top surface of the cooling sandwich.

The temperature compensation device includes a substrate compensation device.

A hot filament spacing D between parallel hot filaments is adjusted to be in a range of 4 mm to 12 mm.

A substrate spacing H between a hot-filament plane and the substrate is adjusted based on the hot filament spacing D through a first formula.

The deposition chamber is evacuated to vacuum.

Hydrogen gas and methane in a proportion are introduced to a target pressure. Hot-filament heating is turned on, and timing is started when a top surface of a deposition substrate reaches a preset temperature.

Hot-filament heating is turned off to start cooling when a deposition time reaches a preset time.

The hydrogen gas is discharged from a furnace after the cooling is completed and a diamond film layer is detached from a surface of the deposition substrate to obtain the diamond.

Preferably, the diameter of the diamond prepared is greater than or equal to 300 mm. Preferably, a surface reflectance of the temperature compensation device near the substrate and the cooling sandwich mechanism is high. Preferably, a material of the substrate includes one of silicon, molybdenum, tungsten, or graphite.

Compared with the prior art, advantageous effects of the present invention include that large-area diamond is prepared by HFCVD, and the diameter of the diamond is greater than or equal to 200 mm.

The deposition chamber includes the temperature compensation device, which avoids the tip thermal effect, thereby facilitating substantially uniform temperatures between the center position and the edge position of the substrate during deposition, while preventing cracking or damage of the large-area diamond due to different cooling rates between the edge position and the center position of the substrate during cooling.

The cooling range of the cooling sandwich structure is controlled, such that during deposition, the cooling transfer range of the cooling sandwich structure is confined to a contact surface between the cooling sandwich structure and the substrate, thereby preventing the cooling sandwich structure from affecting the radiation temperature of the hot filaments during deposition and further avoiding non-uniform temperature distribution on the top surface of the substrate caused by the hot filament radiation.

This facilitates obtaining the large-area diamond free from internal structural non-uniformity and having reduced impurities and defects.

Uniform temperatures across the top surface of the substrate can be achieved by adjusting the hot filament spacing D between the parallel hot filaments to be in a range of 4 mm to 12 mm, which avoids problems where small hot filament spacing and large distribution dispersion of the hot filaments lead to temperature fluctuations in the temperature distribution on the substrate in the same direction, corresponding to the hot filament positions, and avoids problems where the concentration of thermal radiation leads to an increase in the temperature difference between the center position and the edge position affected by the hot filaments when the hot filament spacing is large. Furthermore, the hot filament spacing is conducive to assembly.

This further facilitates the obtaining of the large-area diamond free from internal structural non-uniformity and having reduced impurities and defects.

By adjusting the substrate spacing H between the hot-filament plane and the substrate based on the hot filament spacing D through the first formula, problems where an increase in the spacing between the hot filaments leads to increased temperature fluctuations on the surface of the substrate and decreased temperature uniformity are further eliminated. That is, temperature fluctuations on the surface of the substrate caused by changes in the hot filament spacing are compensated by temperature fluctuations caused by the substrate spacing H between the plane where the hot filaments are located and the substrate, which further facilitates uniform temperature distribution on the top surface of the substrate during deposition.

The preparation of large-area, high-quality diamonds with few impurities and defects is ultimately achieved.

Further, the first formula is expressed as: $H = 4.5 + {\left(D-3\right)}^{\frac{3}{4}}$, *3*wherein D is in a range of 4 mm to 12 mm.

The above setting provides the following advantageous effects, including uniform temperatures across the top surface of the substrate are achieved, thereby avoiding problems where small hot filament spacing and large distribution dispersion of the hot filaments lead to temperature fluctuations in the temperature distribution on the substrate in the same direction, corresponding to the hot filament positions, and avoiding problems where the concentration of thermal radiation leads to an increase in the temperature difference between the center position and the edge position affected by the hot filaments when the hot filament spacing is large. Furthermore, the hot filament spacing is conducive to assembly.

This facilitates the obtaining of the large-area diamond free from internal structural non-uniformity and having reduced impurities and defects.

Further, the substrate compensation device is an annular structure, or the substrate compensation device is formed by assembling 2 to 5 arc sections into a circular ring.

A height of the substrate compensation device is flush with or lower than a height of the substrate.

The substrate compensation device is sleeved outside the substrate and is in contact with the substrate.

The substrate compensation device is located on an outer top surface of the cooling sandwich mechanism.

A thermal conductivity of the substrate compensation device is less than or equal to a thermal conductivity of the substrate, and a material of the substrate compensation device includes one of molybdenum, graphite, tantalum, or silicon carbide ceramic.

The above arrangement provides the following advantageous effects, including avoiding the tip thermal effect, thereby facilitating substantially uniform temperatures between the center position and the edge position of the substrate during deposition, while preventing cracking or damage of the large-area diamond due to different cooling rates between the edge position and the center position of the substrate during cooling, thereby facilitating the obtaining of the large-area diamond free from internal structural non-uniformity and having reduced impurities and defects.

Further, the temperature compensation device further includes a thermal radiation compensation device.

The thermal radiation compensation device includes a first arc-shaped plate and a second arc-shaped plate arranged opposite to each other.

The first arc-shaped plate is connected to a first base plate arranged perpendicular to the first arc-shaped plate.

The second arc-shaped plate is connected to a second base plate arranged perpendicular to the second arc-shaped plate.

Further, the thermal radiation compensation device is sleeved outside the cooling sandwich structure.

The cooling sandwich structure is located between the first arc-shaped plate and the second arc-shaped plate.

The first base plate and the second base plate are located below the cooling sandwich structure.

A spacing is provided between ends of the first arc-shaped plate and ends of the second arc-shaped plate.

A minimum distance L between an inner arc surface of the first arc-shaped plate or the second arc-shaped plate and the cooling sandwich mechanism meets a second formula.

The second formula is expressed as: *L=10ε×(20-H)*.

ε denotes a thermal reflectance of the first arc-shaped plate or the second arc-shaped plate; and H denotes the substrate spacing between the hot-filament plane and the substrate.

Preferably, a thermal conductivity of the substrate compensation device is less than or equal to a thermal conductivity of the substrate, and a material of the substrate compensation device includes one of molybdenum, graphite, tantalum, or silicon carbide ceramic.

The above setting provides the following advantageous effects, including controlling the cooling range of the cooling sandwich structure by positioning the cooling sandwich structure between the first arc-shaped plate and the second arc-shaped plate, and locating the first base plate and the second base plate below the cooling sandwich structure, which facilitates, during deposition, controlling the cooling transfer range of the cooling sandwich structure to the contact surface between the cooling sandwich structure and the substrate, thereby preventing the cooling sandwich structure from affecting the radiation temperature of the hot filaments during deposition, and further avoiding non-uniform temperature distribution on the top surface of the substrate caused by the hot filament radiation.

These facilitate obtaining the large-area diamond free from internal structural non-uniformity and having reduced impurities and defects.

Further, the hot filaments are arranged in a rectangular structure. The four corners of the rectangular structure are not located above the spacing between the ends of the first arc-shaped plate and the ends of the second arc-shaped plate.

The thermal radiation compensation device is not in contact with the cooling sandwich mechanism.

The above arrangement provides the following advantageous effects that the four corners of the rectangular structure are not located above the spacing between the ends of the first arc-shaped plate and the ends of the second arc-shaped plate, thereby preventing the cooling effect of the cooling sandwich mechanism from affecting the four corners of a matrix structure of the hot filaments.

Further, the target pressure is in a range of 1000 Pa to 8000 Pa.

Further, a volume ratio of the methane to the hydrogen gas is in a range of (0.5-8):(92-99.5).

The above setting provides the following advantageous effects, including achieving uniform and sufficient contact between the hydrogen gas and the methane, which facilitates uniform diamond deposition without defects.

Further, a preset temperature of a top surface of the substrate is in a range of 800°C to 1000°C.

The above setting provides the following advantageous effects, including avoiding the appearance of graphite phases or defects during diamond film deposition.

Further, the cooling sandwich structure is provided with a liquid inlet and a liquid outlet, and the liquid inlet is connected to a cooling source.

A cooling medium in the cooling sandwich structure is water. An outlet water temperature of the cooling medium is in a range of 40°C to 60°C.

An interface temperature between a deposition and the cooling sandwich structure is in a range of 190°C to 260°C.

The above setting provides the following advantageous effects, including that uniform cooling of the deposition substrate is achieved, thereby facilitating avoiding problems of non-uniform temperature across various parts of the substrate caused by excessively fast cooling and defects during diamond preparation by using water as the cooling medium in the cooling sandwich structure and setting the outlet water temperature of the cooling medium in a range of 40°C to 60°C.

The problems of deformation of the substrate due to prolonged high temperature caused by excessively slow cooling can be avoided by ensuring that the interface temperature between a deposition and the cooling sandwich structure is in a range of 190°C to 260°C.

### BRIEF DESCRIPTION OF THE DRAWINGS

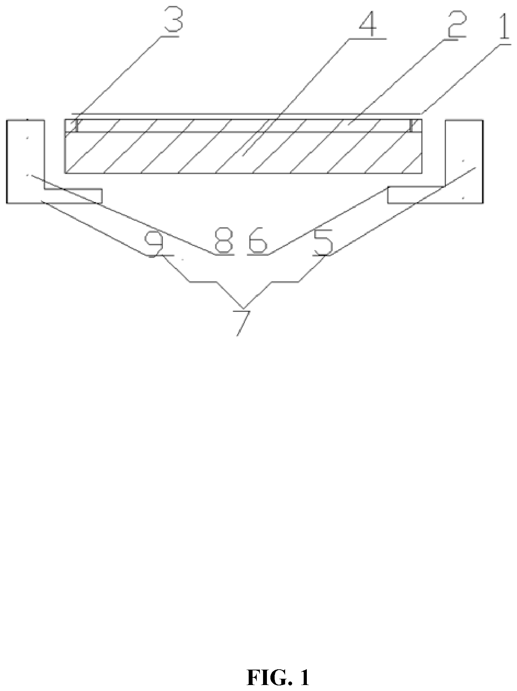

FIG. 1 is a schematic diagram illustrating a structure of a hot-filament assembly, a deposition platform, and a temperature compensation device according to Example 1 of the present invention.

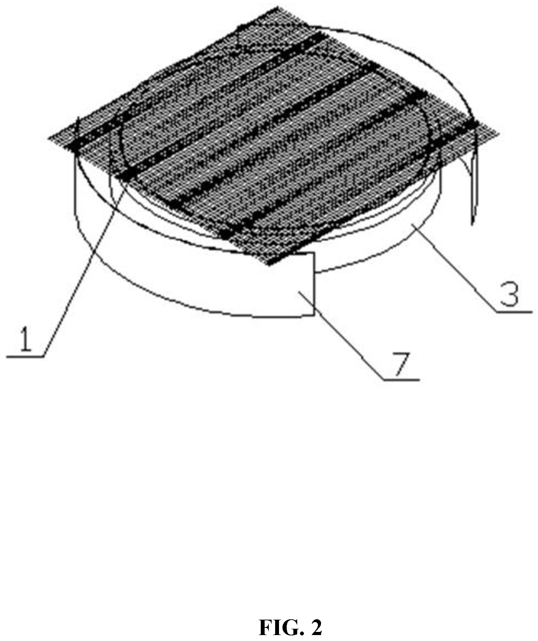

FIG. 2 is a perspective view illustrating the hot-filament assembly, the deposition platform, and the temperature compensation device according to Example 1 of the present invention;

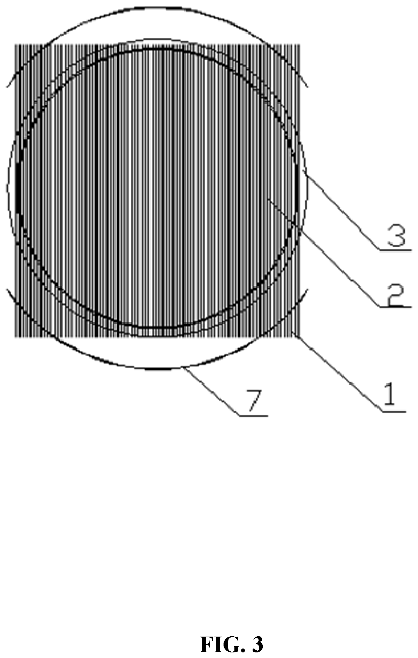

FIG. 3 is a top view illustrating the hot-filament assembly, the deposition platform, and the temperature compensation device according to Example 1 of the present invention;

As shown in the drawings:
1 represents the hot-filament assembly, 2 represents a substrate, 3 represents a substrate compensation device, 4 represents a cooling sandwich structure, 5 represents a first arc-shaped plate, 6 represents a first base plate, 7 represents a thermal radiation compensation device, 8 represents a second arc-shaped plate, and 9 represents a second base plate.

### DETAILED DESCRIPTION

To facilitate a better understanding of the technical solutions of the present invention, the present invention is further described below with reference to the drawings and specific embodiments thereof.

### Example 1

This example provides a method for preparing large-area diamond at a high temperature by HFCVD. The method included the following steps.

The diamond was prepared using an HFCVD apparatus. A diameter of the diamond prepared was 300 mm.

The HFCVD apparatus is provided with a deposition chamber, and the deposition chamber includes a hot-filament assembly 1, a deposition platform, and a temperature compensation device.

The hot-filament assembly 1 includes a plurality of parallel hot filaments.

The deposition platform includes a substrate 2 and a cooling sandwich structure 4. The substrate 2 is placed on a top surface of the cooling sandwich mechanism 4, and a material of the substrate 2 is molybdenum.

The temperature compensation device includes a substrate compensation device 3 and a thermal radiation compensation device 7. The material of the substrate compensation device 3 and the thermal radiation compensation device 7 is molybdenum, and a surface reflectance of the temperature compensation device adjacent to the substrate 2 and the cooling sandwich mechanism 4 is high.

The substrate compensation device 3 is an annular structure, and a height of the substrate compensation device 3 is flush with a height of the substrate 2.

The substrate compensation device 3 is sleeved outside the substrate 2 and is in contact with the substrate 2.

The substrate compensation device 3 is located on an outer top surface of the cooling sandwich mechanism 4.

The thermal radiation compensation device 7 includes a first arc-shaped plate 5 and a second arc-shaped plate 8 arranged opposite to each other.

The first arc-shaped plate 5 is connected to a first base plate 6 arranged perpendicular to the first arc-shaped plate 5.

The second arc-shaped plate 8 is connected to a second base plate 9 arranged perpendicular to the second arc-shaped plate 8.

The thermal radiation compensation device 7 is sleeved outside the cooling sandwich structure 4.

The cooling sandwich structure 4 is located between the first arc-shaped plate 5 and the second arc-shaped plate 8.

The first base plate 6 and the second base plate 9 are located below the cooling sandwich structure 4.

The hot filaments are arranged in a rectangular structure. The four corners of the rectangular structure are not located above the spacing between the ends of the first arc-shaped plate 5 and the ends of the second arc-shaped plate 8.

The thermal radiation compensation device 7 is not in contact with the cooling sandwich mechanism 4.

A hot filament spacing D between the parallel hot filaments was adjusted to be in a range of 4 mm to 12 mm.

A substrate 2 spacing H between a hot-filament plane and the substrate 2 was adjusted based on the hot filament spacing D through a first formula.

The first formula was expressed as: $H = 4.5 + {\left(D-3\right)}^{\frac{3}{4}}$, wherein D was in a range of 4 mm to 12 mm.

A spacing was provided between the ends of the first arc-shaped plate 5 and the ends of the second arc-shaped plate 8.

A minimum distance L between an inner arc surface of the first arc-shaped plate 5 or the second arc-shaped plate 8 and the cooling sandwich mechanism 4 met a second formula.

The second formula was expressed as: *L=10ε×(20-H)*.

ε denoted a thermal reflectance of the first arc-shaped plate 5 or the second arc-shaped plate 8; and H denoted the substrate spacing between the hot-filament plane and the substrate 2.

The deposition chamber was evacuated to vacuum.

Hydrogen gas and methane in a proportion were introduced to a target pressure. Hot-filament heating was turned on. Timing was started when a top surface of the deposition substrate reached a preset temperature, wherein a target pressure for introducing the hydrogen gas and the methane was 4500 Pa, a volume ratio of the methane to the hydrogen gas was 4.3:95.7, and a preset temperature of a top surface of the substrate 2 was 900°C.

A cooling medium in the cooling sandwich structure 4 was water, an outlet water temperature of the cooling medium was 50°C.

An interface temperature between a deposition and the cooling sandwich structure 4 was 225°C.

The hot-filament heating was turned off to start cooling when a deposition time reached a preset time.

After the cooling was completed, the hydrogen gas was discharged from a furnace, and a diamond film layer was detached from a surface of a deposition substrate to obtain the diamond.

### Example 2

The contents of this example that are the same as those of Example 1 are not repeated herein. The differences between this example and Example 1 are as follows. This example provides a method for preparing large-area diamond at a high temperature by HFCVD, including the following steps.

A diameter of the diamond prepared was 350 mm. The material of the substrate 2 was silicon. The material of the substrate compensation device 3 and the thermal radiation compensation device 7 was graphite. The substrate compensation device 3 was formed by assembling 2 to 5 arc sections into a circular ring. The height of the substrate compensation device 3 was slightly lower than the height of the substrate 2.

The target pressure achieved by introducing the hydrogen gas and the methane was 4000 Pa. The volume ratio of the methane to the hydrogen gas was 3:97, and the preset temperature of a top surface of the substrate 2 was 850°C.

The cooling medium in the cooling sandwich structure 4 was water, and an outlet water temperature of the cooling medium was 45°C.

The interface temperature between a deposition and the cooling sandwich structure 4 was 200°C.

### Example 3

The contents of this example that are the same as those of Example 1 are not repeated herein. The differences between this example and Example 1 are as follows. This example provides a method for preparing large-area diamond at a high temperature by HFCVD, including the following steps.

The material of the substrate compensation device 3 and the thermal radiation compensation device 7 was silicon carbide ceramic.

The target pressure achieved by introducing the hydrogen gas and the methane was 7500 Pa. The volume ratio of the methane to the hydrogen gas was 7.7:92.5. The preset temperature of a top surface of the substrate 2 was 980°C.

The cooling medium in the cooling sandwich structure 4 was water, and the outlet water temperature of the cooling medium was 58°C.

The interface temperature between a deposition and the cooling sandwich structure 4 was 255°C. A diameter of the diamond prepared was 400 mm.

Those skilled in the art should understand that the scope of the present invention is not limited to the technical solutions formed by specific combinations of the above-described technical features, but should also cover other technical solutions formed by any combination of the above-described technical features or their equivalent features without departing from the inventive concept. For example, technical solutions formed by mutually replacing the above-described features with technical features having similar functions as those disclosed (but not limited to) in the present invention.

## Claims

1. A method for preparing large-area diamond at a high temperature by hot-filament chemical vapor deposition, HFCVD, comprising the following steps:
preparing the diamond using an HFCVD apparatus, wherein
a diameter of the diamond prepared is greater than or equal to 200 mm;
the HFCVD apparatus is provided with a deposition chamber,
the deposition chamber includes a hot-filament assembly, a deposition platform, and a temperature compensation device;
the hot-filament assembly includes a plurality of parallel hot filaments;
the deposition platform includes a substrate and a cooling sandwich structure,
wherein
the substrate is placed on a top surface of the cooling sandwich; and
the temperature compensation device includes a substrate compensation device;
adjusting a hot filament spacing D between parallel hot filaments to be in a range of 4 mm to 12 mm;
adjusting a substrate spacing H between a hot-filament plane and the substrate based on the hot filament spacing D through a first formula;
evacuating the deposition chamber to vacuum;
introducing hydrogen gas and methane in proportion to a target pressure;
turning on hot-filament heating;
starting timing when a top surface of a deposition substrate reaches a preset temperature;
turning off the hot-filament heating to start cooling when a deposition time reaches a preset time;
discharging the hydrogen gas from a furnace after the cooling is completed; and
detaching a diamond film layer from a surface of the deposition substrate to obtain the diamond.

2. The method according to claim 1, wherein the first formula is expressed as: $H = 4.5 + {\left(D-3\right)}^{\frac{3}{4}}$, wherein D is in a range of 4 mm to 12 mm.

3. The method according to claim 1, wherein
the substrate compensation device is an annular structure, or
the substrate compensation device is formed by assembling 2 to 5 arc sections into a circular ring;
a height of the substrate compensation device is flush with or lower than a height of the substrate;
the substrate compensation device is sleeved outside the substrate and is in contact with the substrate;
the substrate compensation device is located on an outer top surface of the cooling sandwich mechanism;
a thermal conductivity of the substrate compensation device is less than or equal to a thermal conductivity of the substrate; and
a material of the substrate compensation device includes one of molybdenum, graphite, tantalum, or silicon carbide ceramic.

4. The method according to claim 1, wherein
the temperature compensation device further includes a thermal radiation compensation device;
the thermal radiation compensation device includes a first arc-shaped plate and a second arc-shaped plate arranged opposite to each other;
the first arc-shaped plate is connected to a first base plate arranged perpendicular to the first arc-shaped plate; and
the second arc-shaped plate is connected to a second base plate arranged perpendicular to the second arc-shaped plate.

5. The method according to claim 4, wherein
the thermal radiation compensation device is sleeved outside the cooling sandwich structure;
the cooling sandwich structure is located between the first arc-shaped plate and the second arc-shaped plate;
the first base plate and the second base plate are located below the cooling sandwich structure;
a spacing is provided between an end of the first arc-shaped plate and an end of the second arc-shaped plate; and
a minimum distance L between an inner arc surface of the first arc-shaped plate or the second arc-shaped plate and the cooling sandwich mechanism meets a second formula, wherein
the second formula is expressed as: *L=10ε×(20-H)*; wherein
ε denotes a thermal reflectance of the first arc-shaped plate or the second arc-shaped plate; and
H denotes the substrate spacing between the hot-filament plane and the substrate.

6. The method according to claim 5, wherein
the hot filaments are arranged in a rectangular structure;
four corners of the rectangular structure are not located above the spacing between the end of the first arc-shaped plate and the end of the second arc-shaped plate; and
the thermal radiation compensation device is not in contact with the cooling sandwich mechanism.

7. The method according to claim 1, wherein the target pressure achieved by introducing the hydrogen gas and the methane is in a range of 1000 Pa to 8000 Pa.

8. The method according to claim 1, wherein a volume ratio of the methane to the hydrogen gas is in a range of (0.5-8):(92-99.5).

9. The method according to claim 1, wherein a preset temperature of a top surface of the substrate is in a range of 800°C to 1000°C.

10. The method according to claim 1, wherein
the cooling sandwich structure is provided with a liquid inlet and a liquid outlet,
the liquid inlet is in communication with a cooling source;
a cooling medium in the cooling sandwich structure is water;
an outlet water temperature of the cooling medium is in a range of 40°C to 60°C; and
an interface temperature between a deposition and the cooling sandwich structure is in a range of 190°C to 260°C.
